# NEW EUROPEAN PATENT SPECIFICATION

(11) **EP 0 275 093 B2**
(45) Date of publication and mention of the opposition decision: **21.06.2000**
(45) Mention of the grant of the patent: 17.06.1992
(21) Application number: 88100395.8
(22) Date of filing: 13.01.1988
(51) Int. Cl.: H03H 1/00

(54) **Distributed constant type noise filter**
Entstörfilter mit verteilten Konstanten
Filtre anti-parasites du type à constantes réparties

(30) Priority: 14.01.1987 JP 496887
(43) Date of publication of application: 20.07.1988
(73) Proprietor: Ikeda, Takeshi, Ohta-Ku Tokyo 143 (JP)
(72) Inventor: Ikeda, Takeshi, Ohta-Ku Tokyo 143 (JP)
(74) Representative: Müller, Frithjof E., Dipl.-Ing.

(56) References cited:
- EP-A- 0 126 446
- DE-C- 720 063
- DE-C- 802 578
- DE-U- 7 026 843
- DE-U- 7 318 735
- FR-A- 2 383 553
- GB-A- 934 890
- PATENT ABSTRACTS OF JAPAN, vol. 9, no. 165 (E-327)[1888], 10th July 1985 & JP-A-60-39 910
- Siemens-Datenbuch 1960/69 "Funk-Entstörung", Seiten 30 bis 63

## Description

The present invention relates generally to a noise filter, more specifically to a distributed constant type noise filter and a method of making such noise filter suited for DC power supply circuits or power circuits for analog or digital ICs (integrated circuits) or the like.

### Prior Art and Problems Thereof

Electronic circuits are normally designed to operate on a DC power supply voltage obtained from a battery or a utility AC power supply in conjunction with a rectifier circuit. DC-DC converters (also known as switching type regulators) are commonly used for obtaining one or more DC voltages of any desired magnitude. Transient currents caused by switching or other electrical phenomena including load fluctuations due to switching operation of digital ICs or the like introduce noise of various frequency components into such power supply circuits. The noise may cause malfunctions or effects reducing the S/N ratio of other nearby electronic equipment or appliances through the supply line or electrical radiation.

Usually, noise filters are used to protect or reduce such noise. Additionally, regulations for noise reduction are becoming increasingly strict mainly because of an increasing circulation of a variety with high performances and sensitive electronic equipments.

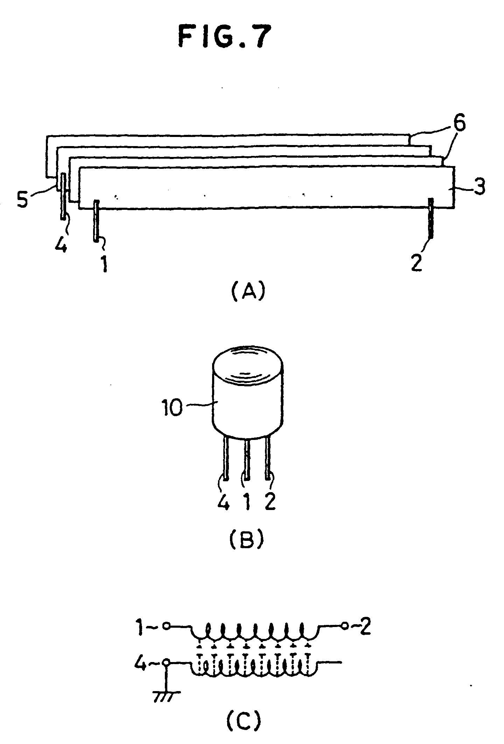

Almost all commercially available noise filters are made of a combination of discrete inductors and capacitors or lumped LC (inductance-capacitance) devices comprising a capacitor and bead cores mounted around its lead wires to increase the inductance. However, some publications such as, for example,JP-A1 54-83736, EP-A-0 126 446 propose distributed constant type noise filters. A simple example of such noise filters is illustrated in Fig. 7(A) showing in an unrolled condition a belt-shaped current carrying conductor 3 and a similar ground conductor 5 such as aluminum laminated with relatively wide dielectric sheets 6. The generally tubular form of such prior art noise filters in the assembled condition is shown in Fig. 7(B). Coupled near to both ends of the current carrying conductor 3 are lead wires 1 and 2. Also coupled near to one end of the ground conductor 5 is a ground lead wire 4. The inductance formed between both lead wires 1 and 2 depends on the number of turns and the length of the current carrying conductor 3. A certain large capacitance is developed between the current carrying conductor 3 and the ground conductor 5 because they are opposed to each other with the thin dielectric sheet 6 therebetween. An equivalent circuit of the resulting distributed constant type noise filter is illustrated in Fig. 7(C).

Such distributed constant type noise filter is relatively simple and yet has relatively good attenuation characteristic over a wide frequency range. But no one has ever attempted to commercially make such noise filters. The primary reasons include the difficulty in making the connection of at least three load wires despite a required relatively small size resulting in a low production yield. Thus, noise filters of such type are unsuitable for quantity production because of unavoidable large differences in attenuation characteristics and lead wire misalignment.

In a publication by Siemens called "Funk-Entstörung - Datenbuch 1968/69" (Noise Suppression - Data Book 1968/69) on page 45 a noise or interference filter is depicted which comprises two lead wires and one ground lead wire wherein the ground lead wire is shifted by 1/4 turn with respect to the first lead wire. Moreover on page 52 an embodiment designated as B81711-B-B3 is shown which has an oval cross section and wherein the two lead wires and the ground lead wire are arranged on the longitudinal axis of the oval form.

The DE-U 7 026 843 discloses an electrical device having inductive and capacitive properties, the device being comprised by at least two coils of a sheet material, respectively, and wound side by side in a spiral manner. The coils have input and output lead wires the distance of which in the plane of the sheet material is set so as to provide the desired inductance and capacitance values of the electrical device.

### Object of the invention

It is therefore an object of this invention to provide a distributed constant type noise filter which has on the one hand satisfying attenuation characteristics and is on the other hand compact and suitable for quantity production without the potential danger of short-circuit between the lead wires.

### Summary of the invention

The noise filter according to the present invention is constructed according to the features of the appended claim 1.

In particular, a noise filter according to the present invention is constructed as to meet the following requirements:
(1) The current carrying conductor and the ground conductor are wound with one (or a first) lead wire of the current carrying conductor and the ground lead wire of the ground conductor close to each other to obtain an excellent attenuation characteristic.
(2) The three lead wires are aligned in line when the noise filter is brought into substantially tubular form with oval cross section by pressing after the winding for facilitating the inserting of the lead wires into holes in a printed circuit board with appropriate distance among lead wires and also to provide resistance against physical stress caused by heat during a soldering operation.

In particular, the winding shaft is chosen to be small enough (approximately 2 to 3 mm) and the distance between the first lead wire of the current carrying conductor and the ground lead wire of the ground conductor is selected in the range of approximately 1/4 to 3/4 turn, more preferably to 1/4 to 1/2 turn. The second lead wire of the current carrying conductor is on or near one of the extension lines including the central axis and the first or ground lead wire. In this manner, the distance between the first lead wire and the ground lead wire is substantially 2.5 % of the entire distance between the first and second lead wires when the current carrying conductor and the ground conductor are spread. After winding, the wound conductors and dielectric films are removed from the shaft and pressed into an oval shape in such direction that the three lead wires align in a substantially straight line. The winding may be coated with epoxy or other suitable resin.

### Embodiments of the Invention

Further details and advantages of the invention may be learned from the following embodiment description in connection with the accompanying drawings wherein
- Figs. 1(A), (B), (C) and (D), (E), (F): are general views of two embodiments of noise filters according to this invention; (A) and (D), respectively, depicting the windings 10 of the conductors and the dielectric sheets seen from the lead wire side, while (B) and (E), respectively, show the compressed winding 10 seen from the lead wire side. (C) and (F), respectively, are perspective views of the finished noise filters. In Fig. 1, the winding direction of the conductors and the dielectric sheets is clockwise.
- Fig. 2: shows an unwound spread presentation of the current carrying and ground conductors.
- Figs. 3, 4 and 5: are graphical presentations of the attenuation characteristics of noise filter samples comprising features of the present invention.
- Figs. 6(A) to (D): show general views of an example of the lead wire arrangement of a noise filter according to another embodiment of the invention using relatively long current carrying and ground conductors, and
- Figs. 7(A) to (C),: showing a conventional distributed constant type noise filter, have already been explained in connection with the above discussion of the prior art.

The same reference numerals are used throughout all Figures for the same or corresponding parts.

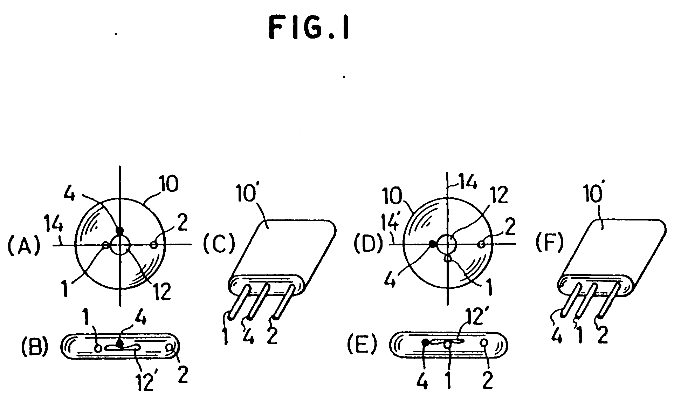

In the first embodiment shown in Figs. 1(A) through (C), a first lead wire 1 of a current carrying conductor 3 is first placed around a shaft 12 of about 2 to 3 mm in diameter. A ground lead wire 4 of a ground conductor 5 is then placed at 1/4 to 1/2 rotary position or turn from the first lead wire 1. Then, both of the current carrying conductor 3 and the ground conductor 5 of predetermined length are wound continuously and a second lead wire 2 of the current carrying conductor 3 comes in a position on or near the horizontal symmetry axis 14 coupling the first lead wire 1 and the center of the shaft 12. The end of the winding 10 is glued before removing the winding 10 from the shaft 12. The winding 10 is compressed perpendicular to the axis 14, thereby deforming the center space 12' of the shaft 12 as shown in Fig. 1(B), thereby bringing the lead wires 1, 2 and 4 in line with substantially increased space between two adjacent lead wires. The ground lead wire 4 may be placed about 1/4 turn ahead of the first lead wire 1 to provide for a symmetrical lead wire arrangement with respect to the axis 14. A finished noise filter comprises a generally oval winding portion 10' and three inline lead wires 1, 2 and 4 extending from one side of the winding portion 10'. The winding portion 10' may be placed in a casing made of a metal foil or provided with a protective coating of epoxy or other suitable material. In this particular embodiment of the noise filter, the ground lead wire 4 is placed between the first and second lead wires 1 and 2 of the current carrying conductor 3.

Now, in the case of the second embodiment of the noise filter according to this invention as shown in Figs. 1(D) through (F), the first lead wire 1 and the ground lead wire 4 are shifted by about 1/4 turn, but it differs from the first embodiment, in that the second lead wire 2 is on the symmetry axis 14' including the ground lead wire 4. Since the winding is compressed perpendicular to the axis 14' as shown in Fig. 1(E), the three lead wires are arranged in line in the sequential order 4-1-2. Unlike the case shown in Fig. 1(D), the ground lead wire 4 may be placed ahead of the first lead wire 1 by about 1/4 turn to provide a symmetrical lead wire arrangement with respect to the axis 14'.

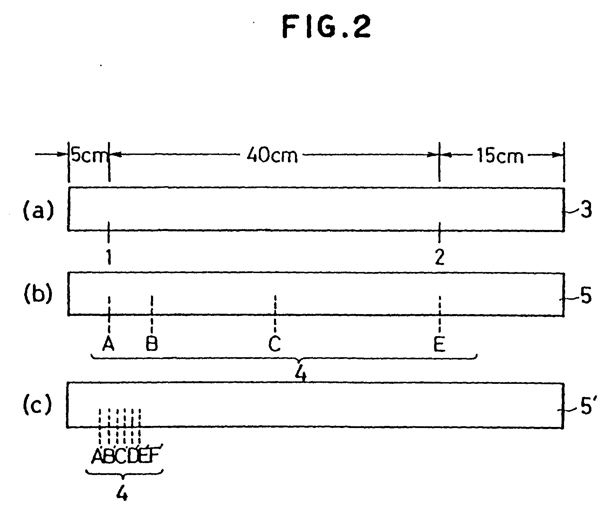

The attenuation characteristic of the noise filter according to this invention will be described hereunder by reference to Figs. 2 through 6.

Shown in Fig. 2 are spread current carrying and ground conductors 3 and 5 to show how the relative position of the first and second lead wires 1 and 2 and the ground lead wire 4 effects performance or attenuation characteristics of the noise filter. In experiments to study the effects of this invention, aluminum foils of 60 cm length, 10 mm width and 50 µm thickness are used for the conductors 3 and 5 as shown in Fig. 2. A mylar tape of 12 mm width and 25 µm thickness is used for the dielectric sheets 6 (not shown in Fig. 2). A wire of 0.8 mm in diameter is used for the lead wires 1, 2 and 4. As shown in Fig. 2(A), the first lead wire 1 is connected to the current carrying conductor 3 at 5 cm from the left end. The distance between the first and second lead wires 1 and 2 is chosen to be about 40 cm and the conductors are wound about 25 turns. The ground lead wire 4 of the ground conductor 5 is set to a position B shifted to the right by 2 cm from the first lead wire position A, the midpoint C between both lead wires 1 and 2 and position E, being substantially equal to the position of the second lead wire 2.

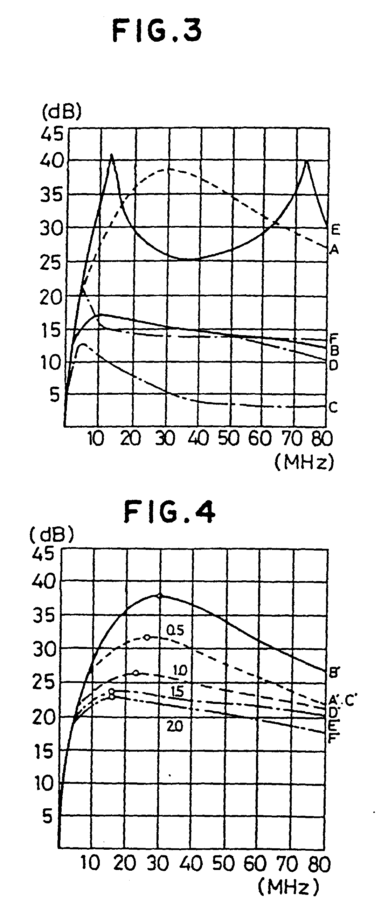

The attenuation characteristic of these noise filter samples is shown in Fig. 3. It is apparent that the noise filters having the ground lead wire 4 connected very close to either the first lead wire 1 or the second lead wire 2 exhibit excellent attenuation characteristic and that the attenuation decreases significantly to useless values if the ground lead wire 4 is apart from the first or second lead wire 1, 2 like positions B and C. However, both lead wires 1-4 or 2-4 are close together and only separated by the thin dielectric sheet 6 in the noise filters having the ground lead wire 4 at the position A or E. They are also not practical because of a potential danger of short-circuit between such lead wires during wiring or soldering operations. Experiments have been made for determining the attenuation characteristic with noise filter samples having the ground lead wire 4 sequentially shifted from the reference position B' corresponding to the first lead wire 1 by 0.5 cm as shown by positions A' through F' in Fig. 2(C).

The resulting attenuation characteristic curves are illustrated by curves A' through F' in Fig. 4. Fig. 4 shows that attenuation reaches the maximum at a position B' where the ground lead wire 4 overlaps the first lead wire 1 and decreases as it departs from the first lead wire 1. Apparently, there is no appreciable difference in attenuation in which direction the ground lead wire 4 departs with respect to the first lead wire 1. That is, the ground lead wire may be ahead or lagged in winding procedure with respect to the first lead wire 4. The experiments also show that only 0.5 cm shift (1.25 % of the entire length of the conductor between the lead wires 1 and 2) causes about 6 dB drop of the maximum attenuation (about 16 % but about 1/2 in linear scale) and about 11 dB (about 29 %) for the 1 cm (2.5 %) shift. A shift of 2,5% turns out to provide satisfying attenuation characteristics and to sufficiently reduce the potential danger of short-circuit in mass production of the noise filters.

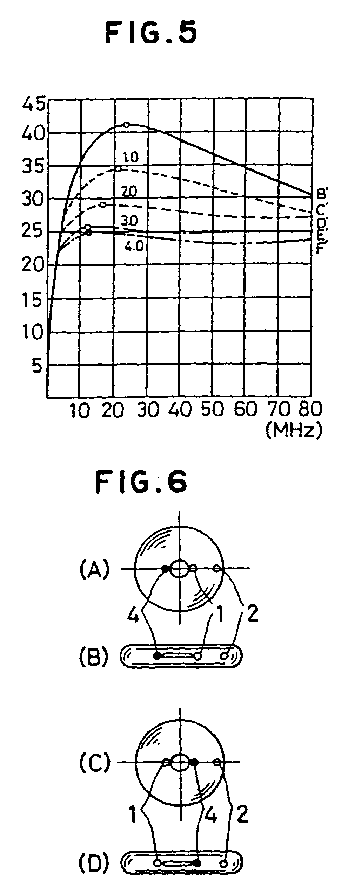

Similar experiments were made with other noise filter samples using the current carrying conductor 3 and the ground conductor 5 that are about 100 cm in total length and 80 cm between the first lead wire 1 and the second lead wire 2, which are twice as long as in the above mentioned samples. This is to verify the attenuation characteristic for different sizes. Fig. 5 shows the results. That is, the maximum attenuation drops about 5 dB as the ground lead wire 4 departs from the first lead wire 1 as much as 1 cm, which is substantially the same proportion as that of the first samples with respect to the distance between the first lead wire 1 and the second lead wire 2.

As is evident from the above description, it is important for foil type distributed constant noise filters to wind the current carrying conductor 3 and the ground conductor 5 around a sufficiently small diameter shaft 12 with the first lead wire 1 of the current carrying conductor 3 and the ground lead wire 4 of the ground conductor 5 shifted by about 1/4 to 1/2 turn, or about 1/4 to 3/4 turn in case of fairly large distance between the first lead wire 1 and the second lead wire 2. Needless to say that excellent attenuation is impossible for such noise filters having the first lead wire 1 and the ground lead wire 4 departing more than one turn even if their angular separation is 1/4 to 1/2 (or 3/4) of a complete rotation. In the event of locating the ground lead wire 4 close to the second lead wire 2, the outer diameter of the winding section 10 of the noise filter is so large that shifting the ground lead wire 4 from the second lead wire 2 by, for example, 1/2 turn for in-line alignment of the three lead wires, may result in a considerably large percentage departure from the second lead wire, thereby causing significant drop in attenuation. Consequently, the noise filters shown in Fig. 1 are an optimum in respect to uniformity of electrical characteristics and suitability for mass production.

The arrangement of the first lead wire 1, the second lead wire 2 and the ground lead wire 4 may be either as in Fig. 1(C) or as in Fig. 1(F) for a relatively low frequency range, whereas the arrangement of Fig. 1(C) having the ground lead wire 4 between the first lead wire 1 and the second lead wire 2 is preferable for higher frequency (100 MHz or higher) applications. It is assumed that high frequency components of the input signal tend to directly couple from the first lead wire 1 to the second lead wire 2 which are relatively close to each other. Also, it is more effective to use a wider ground conductor than the current carrying conductor. The first and second lead wires may be used as the signal input and output terminals or vice versa. However, the characteristic curve of Fig. 3(A) depicts the case where the first and second lead wires are used as input and output terminals, respectively. On the other hand, the characteristic curve of Fig. 3(E) represents the so-called choke-input type noise filter replacing the first and second lead wires from the capacitor-input type. The latter noise filter provides larger attenuation at relatively low frequencies of about 10 MHz, but the attenuation drops at a 30 to 50 MHz frequency range. It is suggested that a cascade connection of these two different noise filters provides a composite noise filter of excellent attenuation over a wide frequency range.

In case of noise filters using relatively long current carrying and ground conductors and with relatively large number of turns, the ground lead wire 4 and the first lead wire 1 may be separated by about 1/2 turn with the second lead wire 2 on the symmetry line coupling the ground lead wire 4 and the first lead wire 1 as shown in Figs. 6(A), (B) or (C), (D). In the embodiment of Figs. 6(A) and (B) the ground lead wire 4 is in the outer position while in the mid-position of the first and second lead wires for the embodiment of Figs. 6(C) and (D). In these cases, the distance between the first lead wire 1 and the ground lead wire 4 is about 5 mm in the finished noise filter when winding around the shaft 12 having a diameter of 3 mm.

Although the aforementioned noise filters are all normal mode using a single current carrying conductor and a single ground conductor, this invention is applicable to common mode type noise filters using two pairs of current carrying and ground conductors. In this case, the first and ground lead wires of each pair of current carrying and ground conductors are shifted by about half turn with respect to the winding shaft.

Also, the ground conductor 5 may be divided into two or more sections rather than using a continuous or single piece as in the above described embodiments. A ground lead wire is connected to each ground conductor section. The use of divided ground conductor helps to increase the maximum attenuation. It is essential in this example to maintain the above mentioned relationship between the first lead wire 1 of the current carrying conductor 3 and the ground lead wire 4 of the ground conductor 5 for obtaining a uniform attenuation characteristic. That is, the first lead wire 1 and the ground lead wire of the first ground conductor section are positioned close enough to each other.

A magnetic core may be inserted in the center of the winding or a magnetic conductor may be used as the current carrying or the ground conductor, respectively, in order to increase the inductance.

### Advantages of the Invention

As described above, the distributed constant type noise filter according to this invention sets the first lead wire of the current carrying conductor and the ground lead wire of the ground conductor within one turn, more preferably 1/4 to 3/4 turn, and the second lead wire of the current carrying conductor on or near the symmetry axis including the center of the winding shaft and the first or the ground lead wire. In this way, the attenuation characteristic of the noise filter is well controlled within a certain predictable range and the three lead wires are positioned in a predetermined in-line arrangement, thereby enabling the manufacture of such noise filters in large quantity. Consequently, this invention overcomes problems associated with conventional noise filters including non-uniformity of the electrical characteristics and low production yield.

## Claims

1. A distributed constant type noise filter comprising a current carrying foil conductor (3) having first and second lead wires (1, 2) and a ground foil conductor (5) having a ground lead wire (4), said both conductors (3, 5) being wound in a generally tubular form with dielectric sheets (6) therebetween, **characterized in** that said ground lead wire (4) is connected close enough to said first lead wire (1) but separated therefrom with an effective distance between said ground lead wire and said first lead wire of substantially 2.5 % of the distance between said first and said second lead wires (1, 2), said first, second and ground lead wires being arranged substantially in-line to each other.

## Patentansprüche

1. Entstörfilter mit verteilten Konstanten, mit einem stromführenden Folienleiter (3) mit einem ersten und einem zweiten Anschlußdraht (1, 2) und einem Massefolienleiter (5) mit einem Masseanschlußdraht (4), wobei die beiden Leiter (3, 5) in im wesentlichen Rohrform mit dielektrischen Blättern (6) zwischen diesen gewickelt sind, **dadurch gekennzeichnet,** daß der Masseanschlußdraht (4) ausreichend dicht am ersten Anschlußdraht (1) angeschlossen ist, jedoch von diesem mit einer effektiven Entfernung zwischen dem Masseanschlußdraht und dem ersten Anschlußdraht getrennt, der im wesentlichen 2,5 % des Abstandes zwischen dem ersten und dem zweiten Anschlußdraht (1, 2) entspricht, wobei der erste, der zweite und der Masseanschlußdraht im wesentlichen in einer Linie zueinander angeordnet sind.

## Revendications

1. Filtre anti-parasites du type à constantes réparties, comprenant un conducteur (3) en lame conduisant le courant, ayant un premier et un second fils (1, 2) d'amenée de courant, et un conducteur (5) en lame à la masse ayant un fil (4) d'amenée de courant à la masse, lesdits deux conducteurs (3, 5) étant enroulés en une forme généralement tubulaire, avec des feuilles diélectriques (6) entre eux, caractérisé en ce que ledit fil (4) d'amenée de courant à la masse est connecté assez près dudit premier fil (1) d'amenée de courant, mais séparé de celui-ci avec une distance effective entre ledit fil d'amenée de courant à la masse et ledit premier fil d'amenée de courant égale sensiblement à 2,5% de la distance entre lesdits premier et second fils (1, 2) d'amenée de courant, lesdits premier et second fils d'amenée de courant et ledit fil d'amenée de courant à la masse étant sensiblement en ligne les uns avec les autres.
